# EUROPÄISCHE PATENTSCHRIFT

(11) **EP 0 432 386 B1**
(45) Veröffentlichungstag und Bekanntmachung des Hinweises auf die Patenterteilung: **21.04.1993**
(21) Anmeldenummer: 90118156.0
(22) Anmeldetag: 21.09.1990
(51) Int. Cl.: G01R 35/04, G01R 11/24, G01R 21/08

(54) **Anordnung zur Ermittlung von Werten elektrischer Grössen, die von Messwerten mindestens zweier elektrischer Eingangsgrössen der Anordnung ableitbar sind**
Arrangement to determine the values of electrical variables, that can be derived from at least two electrical input signals of the arrangement
Dispositif pour déterminer les valeurs des variables électriques, que peuvent être dérivés d'au moins deux signaux d'entrée du dispositif

(30) Priorität: 14.12.1989 CH 4497/89
(43) Veröffentlichungstag der Anmeldung: 19.06.1991
(73) Patentinhaber: Landis & Gyr Business Support AG, 6301 Zug (CH)
(72) Erfinder: De Vries, Jacob, CH-6319 Allenwinden (CH); Lienhard, Heinz, CH-6300 Zug (CH)

(56) Entgegenhaltungen:
- EP-A- 0 109 644
- EP-A- 0 163 440
- DE-A- 3 126 485
- DE-A- 3 323 961
- DE-A- 3 743 064
- PATENT ABSTRACTS OF JAPAN, Band 6, Nr. 141 (P-131)[1019], 30. Juli 1982; & JP-A-57 63 461

## Beschreibung

Die Erfindung bezieht sich auf eine Anordnung zur Ermittlung von Werten elektrischer Grössen, die von Messwerten mindestens einer elektrischen Eingangsgrösse der Anordnung ableitbar sind, gemäss dem Oberbegriff des Anspruchs 1.

Solche elektrische Grössen sind vorzugsweise Kenngrössen einer elektrischen Versorgungseinrichtung, wie die Werte von Voltstunden, Voltquadratstunden, Amperestunden, Amperequadratstunden, Wirkleistungen, Wirkenergien, Blindleistungen, Blindenergien, Scheinleistungen, Scheinenergien, Leistungsfaktoren oder die Effektivwerte von Spannungen oder Strömen, die alle ableitbar sind von den Messwerten einer elektrischen Spannung und eines zu der Spannung gehörenden elektrischen Stromes. In Frankreich werden z. B. sogenannte "Tarif bleu"-Elektrizitätszähler eingesetzt, in denen neben dem Wirkenergieverbrauch auch die Effektivwerte von Lastströmen ermittelt werden.

Mindestens eine elektrische Spannung und der dazugehörige elektrische Strom sind vorzugsweise zwei Eingangsgrössen der Anordnung, wobei z. B. die Spannung eine Netzspannung eines Einphasen-Energieversorgungsnetzes oder die Phasenspannung eines Dreiphasen-Energieversorgungsnetzes und der Strom ein dazugehöriger Laststrom ist.

Anordnungen der eingangs genannten Art werden vorteilhaft in Multifunktionsmetern verwendet. Eine derartige Anordnung ist aus der EP 0 163 440 A1 bekannt, in der die Fälschung eines mittels eines Elektrizitätszählers gemessenen Energieverbrauchs (Hauptgrösse) erkannt wird durch die gleichzeitige Messung mittels eines Stromtransformators einer zweiten Messgrösse (Nebengrösse), nämlich der verbrauchten Amperestunden. Die Messung der letzteren stellt eine sehr grobe und daher sehr ungenaue Messung des Energieverbrauchs dar, weil sie eine konstante und daher nicht gemessene Netzspannung voraussetzt.

Aus der DE 33 23 961 A1 ist der Einsatz eines umgeschalteten Hallelementes und eines Analog/Digital-Wandlers in Elektrizätszählern bekannt zur Messung der Wirk- und der Blindenergie. Aus der EP 0 109 644 A2 ist der Einsatz von Hallelementen und Spannungs/Frequenz-Wandlern in Elektrizätszählern bekannt zur Messung der Wirk- und der Blindenergie. Aus der DE-37 43 064 ist die Messung mehrerer Energiewerte mittels ungeeichter Elektrizitätszähler bekannt, deren Messwerte mittels eines Korrekturfaktors korrigiert werden, der gleich dem Verhältnis der Summe aller Messwerte und eines Gesamtenergiewertes ist, welcher letzterer mittels eines geeichten Elektrizitätszählers gemessen wird. Aus der JP 57-63461 A ist das Testen eines Elektrizitätszählers bekannt mit einer Analog/Digital-Wandler aufweisenden Energiemesseinrichtung. Aus der DE 31 26 485 A1 ist eine dreiphasige Messanordnung bekannt zur Messung von Spannungen, Strömen, Wirkleistungen, Blindleistungen, Scheinleistungen und Leistungsfaktoren. Momentanwerte der Spannungen und der dazugehörigen Ströme werden dabei periodisch mittels Abtast/Halte-Schaltungen und Analog/Digital-Wandlern erfasst. Die zu ermittelnden Grössen werden anschliessend in einer Zentraleinheit berechnet.

Wird mindestens ein Teil der ermittelten elektrischen Grössen, vorzugsweise eine zu messende Wirkenergie, dazu verwendet, die Kosten eines Energieverbrauchs zu ermitteln, dann müssen die elektrischen Grössen dieses Teils, welche nachfolgend als Hauptgrössen bezeichnet werden, durch die Anordnung mit grosser Genauigkeit und vorallem grosser Fälschungs- und Betrugssicherheit ermittelt werden. Beim andern Teil der elektrischen Grössen, die dann als Nebengrössen bezeichnet werden und von sekundärer Bedeutung sind, spielt die Genauigkeit und die Fälschungs- und Betrugssicherheit eine weniger wichtige Rolle, da für diese Grössen oft grössere Fehler zugelassen werden und eine Fälschung an sich weniger interessant ist, da der mit diesen Nebengrössen bestimmte Kostenanteil wesentlich kleiner ist.

Anordnungen mit Abtast/Halte-Schaltungen sind insofern nicht fälschungssicher, da z. B. ein Energieverbrauch relativ einfach in den Impulslücken der Abtastungen gelegt und mit diesen synchronisiert werden kann, so dass während der Abtastimpulse kein Energieverbrauch erfolgt und die Ermittlung des Energieverbrauchs mittels dieser Abtastimpulse immer einen Wert Null ergeben würde.

Der Erfindung liegt die Aufgabe zugrunde, eine Anordnung der eingangs genannten Art zu verwirklichen, in der eine möglichst grosse Anzahl verschiedener Arten elektrischer Grössen möglichst universell ermittelt werden, wobei im Gegensatz zu den meisten Grössen besonders wichtige elektrische Grössen als Hauptgrössen mit grosser Genauigkeit und hoher Fälschungsicherheit ermittelt werden.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen.

Ausführungsbeispiele der Erfindung sind in der Zeichnung dargestellt und werden im folgenden näher beschrieben.

Es zeigen:
- Fig. 1: ein Blockschaltbild einer ersten Variante einer einphasigen Anordnung,
- Fig. 2: ein Blockschaltbild einer zweiten Variante der einphasigen Anordnung,
- Fig. 3: ein Blockschaltbild einer dreiphasigen Anordnung,
- Fig. 4: ein Blockschaltbild einer mit Hallelementen ausgerüsteten Kombination eines Multiplizierers und eines Strom/Spannungs-Wandlers,
- Fig. 5: ein Blockschaltbild eines mit einem Hallelement ausgerüsteten Multiplizierers und
- Fig. 6: ein Schaltbild eines Spannungs/Strom-Wandlers.

Gleiche Bezugszahlen bezeichnen in allen Figuren der Zeichnung gleiche Teile. Die fakultativ vorhandenen Baugruppen und Verbindungen sind in der Zeichnung gestrichelt dargestellt.

Die zu ermittelnden elektrischen Grössen bestehen mindestens aus einer Hauptgrösse und mindestens einer Nebengrösse. Bei der Ermittlung aller Hauptgrössen sind, wie bereits erwähnt, die geforderte Messgenauigkeit und Fälschungssicherheit bedeutend grösser als bei der Ermittlung aller Nebengrössen. Mindestens eine zu messende Wirkenergie ist eine Hauptgrösse. Dann ist mindestens eine der folgenden Grössen, Effektivwert einer Spannung oder eines Stromes, voltstunden, Voltquadratstunden, Amperestunden, Amperequadratstunden, Wirkleistung, Blindleistung, Blindenergie, Scheinleistung, Scheinenergie oder Leistungsfaktor, eine Nebengrösse.

Mindestens eine der Hauptgrössen, vorzugsweise die zu messende Wirkenergie, kann gleichzeitig auch eine Nebengrösse sein, deren Ermittlung dann z. B. zur Ueberwachung der Richtigkeit der ermittelten Werte dieser Hauptgrösse dient. So wird z. B. der Wert einer zu messenden Wirkenergie vorzugsweise zweimal erfasst, einmal sehr genau und fälschungssicher zu Ermittlung eines zugehörigen Preises und einmal annähernd grob zur aus Sicherheitsgründen realisierten ungefähren Kontrolle des korrekten Funktionierens der Anordnung.

In der Zeichnung wurde aus Gründen der zeichnerischen Einfachheit angenommen, dass nur eine einzige Hauptgrösse, nämlich eine zu messende Wirkenergie, durch die Anordnung zu ermitteln sei.

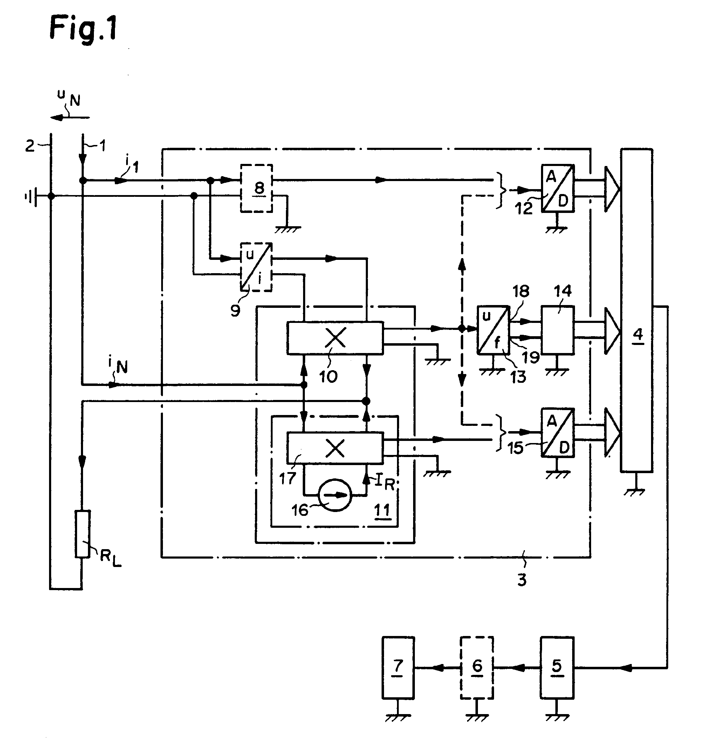

In der in der Fig. 1 dargestellten ersten Variante einer einphasigen Anordnung sind eine Spannung u_{N} und ein dazugehöriger Strom i_{N} eines einphasigen Energieversorgungsnetzes als Eingangsgrössen über zwei Leiter 1 und 2 auf die Anordnung geführt, wobei der Leiter 2 in der Regel ein Nullleiter und z. B. geerdet ist. Ein an das Energieversorgungsnetz angeschlossener Verbraucher ist als Lastwiderstand R_{L} dargestelt.

Die Anordnung besteht aus einer Eingangsschaltung 3, einer Interfaceschaltung 4, einer Rechneranordnung 5, einer fakultativ vorhandenen weiteren Interfaceschaltung 6 und einer Anzeige 7, die in der angegebenen Reihenfolge in Kaskade geschaltet sind.

Die Rechneranordnung 5 ist ein digitales Rechenwerk, vorzugsweise ein Mikrocomputer, und dient der Ermittlung sowie Speicherung der Werte von Haupt- und Nebengrössen. Die Anzeige 7 ist entweder eine mechanische Anzeige, dann enthält die weitere Interfaceschaltung 6 in der Regel einen Schrittmotor, oder eine elektrische Anzeige, wie z. B. eine 7 Segment-Anzeige oder eine Flüssigkristall-Anzeige. Im Fall einer elektrischen Anzeige ist die weitere Interfaceschaltung 6 möglicherweise überflüssig und kann dann weggelassen werden.

Die Eingangsschaltung 3 enthält einen Multiplizierer 10, einen Strom/Spannungs-Wandler 11, einen Signal/Frequenz-Wandler 13 und einen Analog/Digital-Wandler 15, wobei der Strom/Spannungs-Wandler 11 seinerseits aus einer Konstanstromquelle 16 und einem weiteren Multiplizierer 17 besteht und vorzugsweise einen fakultativ vorhandenen Spannungssensor 8, einen fakultativ vorhandenen Spannungs/Strom-Wandler 9, einen weiteren Analog/Digital-Wandler 12 und einen Zähler 14. Der Spannungssensor 8 ist z. B. ein Spannungsteiler oder ein Spannungswandler. Der Zähler 14 ist ein Vorwärts/Rückwärts-Zähler, der zwei Eingänge aufweist, wovon ein erster dem Vorwärts- und ein zweiter dem Rückwärtszählen dient. Der Signal/ Frequenz-Wandler 13 ist z. B. ein Spannungs/Frequenz-Wandler und besitzt zwei Ausgänge 18 und 19, die mit je einem der beiden Eingänge des Zählers 14 verbunden sind. Alle Eingänge des Spannungssensors 8, des Spannungs/Strom-Wandlers 9, des Multiplizierers 10, des Strom/Spannungs-Wandlers 11 und des weiteren Multiplizierers 17 sowie ein erster und zweiter Eingang der Anordnung und der Eingangsschaltung 3 sind zweipolig.

Die Spannung u_{N} speist einerseits den ersten Eingang und über den Lastwiderstand R_{L} den zweiten Eingang der Eingangsschatung 3, wobei dieser erste und zweite Eingang gleichzeitig erster bzw. zweiter Eingang der Anordnung ist. Der erste Eingang der Eingangsschaltung 3 ist innerhalb derselben auf je einen hochohmigen Eingang des Spannungssensors 8 und des Spannungs/Strom-Wandlers 9 geführt. Wenn dagegen der Spannungs/Strom-Wandler 9 nicht vorhanden ist, ist der Eingang der Eingangsschaltung 3 statt auf dessen Eingang auf einen ersten dann hochohmigen Eingang des Multiplizierers 10 geführt. Die Spannung u_{N} speist somit immer entweder mittelbar über den Spannungs/Strom-Wandler 9 oder unmittelbar den ersten Eingang des Multiplizierers 10, sowie mittelbar über den Spannungssensor 8 oder unmittelbar den Eingang des weiteren Analog/Digital-Wandlers 12. Der erste Eingang der Eingangsschaltung 3 ist immer hochohmig, so dass ein in ihm hineinfliessender Strom i₁ gegenüber i_{N} als sehr klein vernachlässigt werden kann. Der gesamte Strom i_{N} speist somit den zweiten Eingang der Eingangsschaltung 3, der innerhalb derselben auf einen Eingang des Strom/Spannungs-Wandlers 11 und auf einen zweiten Eingang des Multiplizierers 10 geführt ist.

Innerhalb des Strom/Spannungs-Wandlers 11 ist dessen Eingang auf einen ersten Eingang des weiteren Multiplizierers 17 geführt, während die Konstantstromquelle 16 einen zweiten Eingang des letzten mit einem konstanten Referenzstrom I_{R} speist. Der Ausgang des weiteren Multiplizierers 17 bildet einen zweipoligen Ausgang des Strom/Spannnungs-Wandlers 11. Je ein Pol der zweipoligen Ausgänge des Spannungssensors 8, des Multiplizierers 10 und des Strom/Spannungs-Wandlers 11 liegen an Masse, welche ebenfalls das Bezugspotential der beiden Analog/Digital-Wandler 12 und 15, des Signal/Frequenz-Wandlers 13, des Zählers 14, der Interfaceschaltung 4, der Rechneranordnung 5, der weiteren Interfaceschaltung 6 und der Anzeige 7 ist. Der nicht an Masse liegende Ausgangspol des Spannungssensors 8 ist über den weiteren Analog/Digital-Wandler 12 auf einen ersten Ausgang der Eingangsschaltung 3 geführt, der seinerseits über eine erste Busverbindung mit einem ersten Eingang der Interfaceschaltung 4 verbunden ist. Der nicht an Masse liegende Ausgangspol des Multiplizierers 10 ist mit dem Eingang des Signal/Frequenz-Wandlers 13 verbunden, dessen beide Ausgänge 18 und 19 über den Zähler 14 auf einen zweiten Ausgang der Eingangsschaltung 3 geführt ist, der seinerseits über eine zweite Busverbindung mit einem zweiten Eingang der Interfaceschaltung 4 verbunden ist. Der nicht an Masse liegende Ausgangspol des Strom/Spannungs-Wandlers 11 ist über den Analog/Digital-Wandler 15 auf einen dritten Ausgang der Eingangsschaltung 3 geführt, der seinerseits über eine dritte Busverbindung mit einem dritten Eingang der Interfaceschaltung 4 verbunden ist.

Die Spannung u_{N} wird entweder nach ihrer Umwandlung in einen proportionalen Strom durch den Spannungs/Strom-Wandler 9 oder direkt dem Multiplizierer 10 zugeführt, in dem sie mit dem Strom i_{N} multipliziert wird, so dass das Ausgangssignal des Multiplizierers 10 proportional dem Produkt u_{N}.i_{N}, d. h. proportional der Wirkleistung ist. Dieses analoge Ausgangssignal wird anschliessend im Signal/Frequenz-Wandler 13 mit grosser Genauigkeit in eine proportionale analoge Frequenz f rechteckförmiger Impulse umgewandelt, die im nachgeschalteten Zähler 14 gezählt werden. Beim Vorliegen eines positiven Wertes der Leistung erreichen die rechteckförmigen Impulse den Zähler 14 über den Ausgang 18 des Signal/Frequenz-Wandlers 13 und werden vorwärts gezählt. Beim Vorliegen eines negativen Wertes der Leistung erreichen die rechteckförmigen Impulse dagegen den Zähler 14 über den Ausgang 19 des Signal/Frequenz-Wandlers 13 und werden rückwärts gezählt. Ein durch diese algebraische Addition der Anzahl Impulse ermittelter digitaler Zählwert des Zählers 14 stellt die Wirkenergie dar und erreicht über die zweite Busverbindung und die Interfaceschaltung 4 die Rechneranordnung 5, in der er gespeichert und möglicherweise weiterverarbeitet wird, z. B. zur Berechnung von Kosten. Die so auf analoge Weise ermittelten digitalen Werte der Hauptgrösse Wirkenergie sind sehr genau und vor allem fälschungssicher, da der Multiplizierer 10, der Signal/Frequenz-Wandler 13 und der Zähler 14 keine Abtast/Halte-Schaltung enthalten.

Der Spannungssensor 8, falls vorhanden, misst die Netzspannung u_{N} und reduziert deren Wert auf einen Wert, der vom weiteren Analog/ Digital-Wandler 12 verarbeitet werden kann. Letzterer wandelt den analogen Wert der Netzspannung u_{N} um in einen zugehörigen proportionalen Digitalwert, welcher über die erste Busverbindung und die Interfaceschaltung 4 der Rechneranordnung 5 zugeleitet wird.

Der weitere Multiplizierer 17 bildet das Produkt I_{R}.i_{N}, wobei der Wert von I_{R} konstant ist, so dass das Ausgangssignal des weiteren Multiplizierers 17 und damit die Ausgangsspannung des Strom/ Spannungs-Wandlers 11 proportional dem Strom i_{N} ist. Der Analog/Digital-Wandler 15 wandelt die dem Strom i_{N} proportionale analoge Ausgangsspannung des Strom/Spannungs-Wandlers 11 um in einen zugehörigen proportionalen Digitalwert, welcher über die dritte Busverbindung und die Interfaceschaltung 4 der Rechneranordnung 5 zugeleitet wird.

Anstelle des konstanten Referenzstromes I_{R} kann der zweite Eingang des Multiplizierers 17 auch mit einem von der Spannung U_{N} abgeleiteten und in der Phase um 90° verschobenen Strom gespeist werden. In diesem Fall entspricht das Ausgangssignal des Multiplizierers 17 der Blindleistung. Zur Weiterverarbeitung kann dann ein weiterer nicht dargestellter Signal/Frequenz-Wandler oder der Analog/Digital-Wandler 15 verwendet werden.

Die Werte der Abtastfrequenzen der in den beiden Analog/Digital-Wandlern 12 und 15 enthaltenen Abtast/Halte-Schaltungen können klein gewählt werden, da mit den Analog/Digital-Wandlern 12 und 15 nur Nebengrössen ermittelt werden.

In der Rechneranordnung 5 sind somit Digitalwerte gespeichert, die proportional der Spannung u_{N} und proportional dem Strom i_{N} sind und die in der Rechneranordnung 5 dazu benutzt werden, gewünschte beliebige Nebengrössen zu berechnen, die von der Spannung u_{N} und dem Strom i_{N} ableitbar sind. Da die beiden Analog/Digital-Wandler 12 und 15 je eine Abtast/Halte-Schaltung enthalten, sind die berechneten Werte der Nebengrössen, wie bereits näher erläutert, weniger fälschungssicher. Sie stellen jedoch Sekundargrössen dar, die zum Manipulieren wenig interessant sind und nur ergänzende Informationen zur Hauptgrösse liefern. So kann z. B. auch die Wirkenergie, ausgehend von den Werten der Spannung u_{N} und des Stromes i_{N}, noch einmal in der Rechneranordnung 5 als Nebengrösse berechnet werden und zu Kontrollzwecken mit der Hauptgrösse Wirkenergie verglichen werden. Die Ermittlung zweier unterschiedlicher Werte für die Wirkenergie dient dann der Detektion von Fehlern in der Anordnung oder von Fälschungen.

Ein ähnliches Resultat wird allerdings auch erreicht, was in der Fig. 1 gestrichelt angedeutet ist, wenn anstelle des Ausganges des Spannungssensors 8 oder des Strom/Spannungs-Wandlers 11 der Ausgang des Multiplizierers 10 auf den betreffenden Analog/ Digital-Wandler 12 bzw. 15 geführt ist. Eine derartig abgeänderte Anordnung ist jedoch weniger universell, da dann entweder die Werte der Spannung u_{N} oder des Stromes i_{N} in der Rechneranordnung 5 fehlen würden. Um dies zu vermeiden, wäre ein dritter Analog/Digital-Wandler, ein vierter Ausgang der Eingangsschaltung 3 und ein vierter Eingang der Interfaceschaltung 4 erforderlich. In jedem Fall erhält die Rechneranordnung 5 über den Analog/Digital-Wandler 12 bzw. 15 Werte der Wirkleistung und kann daraus als Nebengrösse digital die zugehörigen Werte der Wirkenergie ermitteln und diese anschliessend mit den analog ermittelten Werten der Hauptgrösse Wirkenergie vergleichen.

Weist der Vergleich der beiden ermittelten Werte der Wirkenergie eine zu grosse Differenz auf, dann ist die Anordnung entweder defekt oder es liegt ein Betrugsversuch vor.

Wenn die Nebengrössen nur Werte der Spannung u_{N} oder des Stromes i_{N} beinhalten, dann ist einer der beiden Analog/Digital-Wandler 12 oder 15 überflüssig und kann mit seiner zugehörigen Ansteuerungsschaltung 8 bzw. 11 weggelassen werden. In diesem Fall besitzt die Eingangsschaltung 3 nur mehr zwei Ausgänge und die Interfaceschaltung 4 nur mehr zwei Eingänge.

In allen Fällen gilt, dass die beiden elektrischen Eingangsgrössen, Spannung u_{N} und Strom i_{N}, auf je einen der beiden Eingänge des Multiplizierers 10 geführt sind, dessen Ausgang zur Ermittlung mindestens der Hauptgrösse Wirkenergie über den Signal/Frequenz-Wandler 13 mit der Rechneranordnung 5 verbunden ist. Dabei ist mindestens eine der beiden elektrischen Eingangsgrössen der Anordnung oder der Ausgang des Multiplizierers 10 zur Ermittlung mindestens einer Nebengrösse über einen zugehörigen Analog/Digital-Wandler 12 bzw. 15 auf die Rechneranordnung 5 geführt. Wenn diese Eingangsgrösse der Strom i_{N} ist, dann wird sie über den Strom/Spannungs-Wandler 11 und den zugehörigen Analog/Digital-Wandler 15 auf die Rechneranordnung 5 geführt. In einer bevorzugt verwendeten und in der Fig. 1 dargestellten Variante werden jeweils sowohl der Strom i_{N} über den Strom/ Spannungs-Wandler 11 und den diesem nachgeschalteten zweiten Analog/Digital-Wandler 15 als auch die Spannung u_{N} über den fakultativ vorhandenen Spannungssensor 8 und den diesem dann nachgeschalteten weiteren Analog/Digital-Wandler 12 auf die Rechneranordnung 5 geführt.

Die am Ausgang der Eingangsschaltung 3 parallel anstehenden Digitalwerten werden in der Interfaceschaltung 4 z. B. in zeitserielle Werte umgewandelt, die anschliessend zeitseriell zur Rechneranordnung 5 übertragen werden. Die in der Rechneranordnung 5 ermittelten Werte der Haupt- und Nebengrössen werden, gegebenenfalls nach vorhergehender Anpassung in der weiteren Interfaceschaltung 6, zur Anzeige 7 übertragen und dort angezeigt.

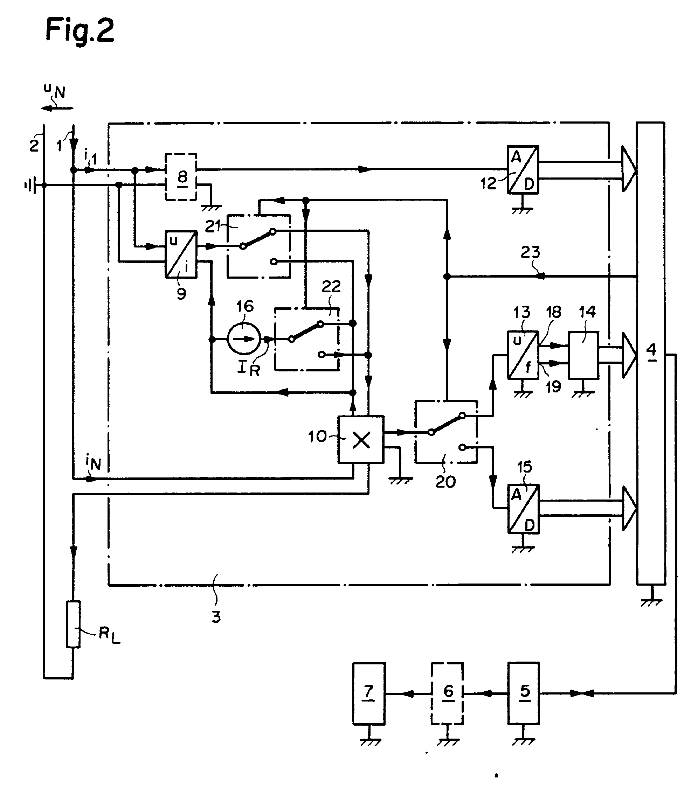

Die in der Fig. 2 dargestellte zweite Variante der einphasigen Anordnung ist ähnlich aufgebaut wie die in der Fig. 1 dargestellte erste Variante mit dem unterschied, dass die beiden Multiplizierer 10 und 17 durch einen einzigen Multiplizierer 10 ersetzt sind und dass zusätzlich drei Umschalter 20, 21 und 22 vorhanden sind, die mittels eines gemeinsamen Steuersignals 23, welches von der Rechneranordnung 5 über die Interfaceschaltung 4 geliefert wird, gleichzeitig umgeschaltet werden. Anstelle der in der Fig. 2 dargestellten drei getrennten einpoligen Umschalter 20 bis 22 kann auch ein einziger dreipoliger Umschalter verwendet werden, dessen drei Umschaltkontakte dann die drei Umschalter 20 bis 22 bilden. In der Fig. 2 sind elektromechanische Umschalter dargestellt, in der Praxis werden jedoch in der Regel statische elektronische Halbleiter-Umschalter verwendet.

Der Strom i_{N} ist in der zweiten Variante wieder auf den zweiten Eingang des Multiplizierers 10 geführt, dessen nicht an Masse liegender Ausgangspol diesmal mittels eines ersten Umschalters 20 entweder auf den Eingang des Signal/Frequenz-Wandlers 13 oder auf den Eingang des zweiten Analog/Digital-Wandlers 15 geführt ist. In der in der Fig. 2 dargestellten zweiten Variante ist der Spannungs/Strom-Wandler 9 vorzugsweise vorhanden, da sein Ausgang schaltungstechnisch dann gleich behandelt werden kann wie der Ausgang der Konstantstromquelle 16. Ein erster Ausgangspol des Spannungs/Strom-Wandlers 9 ist in diesem Fall mittels eines zweiten Umschalters 21 entweder mit dem ersten oder dem zweiten Pol des ersten Eingangs des Multiplizierers 10 verbunden, während ein erster Pol der Konstantstromquelle 16 im Gegentakt dazu mittels eines dritten Umschalters 22 jeweils auf den andern der beiden Pole des ersten Eingangs des Multiplizierers 10 geführt ist, mit dem der erste Ausgangspol des Spannungs/Strom-Wandlers 9 gerade nicht verbunden ist. Der zweite Ausgangspol des Spannungs/ Strom-Wandlers 9 und der zweite Pol der Konstantstromquelle 16 sind ihrerseits miteinander und mit einem der beiden Pole des ersten Eingangs des Multiplizierers 10 verbunden. In der in der Fig. 2 dargestellten Position der beiden Umschalter 21 und 22 fliesst der Ausgangsstrom des Spannungs/Strom-Wandlers 9 von dessen ersten Ausgangspol über den zweiten Umschalter 21 zum ersten Eingang des Multiplizierers 10, während die Konstantstromquelle 16 durch den dritten Umschalter 22 kurzgeschlossen und somit nicht in Betrieb ist. In der andern Position der beiden Umschalter 21 und 22 fliesst dagegen der von der Konstantstromquelle 16 gelieferte Referenzstrom I_{R} über den dritten Umschalter 22 zum ersten Eingang des Multiplizierers 10, während der Ausgang des Spannungs/Strom-Wandlers 9 durch den zweiten Umschalter 21 kurzgeschlossen und somit nicht in Betrieb ist. Die Steuereingänge der drei Umschalter 20 bis 22 sind miteinander verbunden und werden vom Steuersignal 23 angesteuert. Der verbleibende Restteil der in der Fig. 2 dargestellten Anordnung ist gleich aufgebaut wie der entsprechende Teil der in der Fig. 1 dargestellten Anordnung.

Das Steuersignal 23 schaltet die drei Umschalter 20 bis 22 periodisch und gleichzeitig um. Am Ausgang des Multiplizierers 10 erscheint dann periodisch abwechselnd eine Spannung, die entweder proportional dem Produkt u_{N}.i_{N} oder proportional dem Produkt I_{R}.i_{N} ist. Da I_{R} einen konstanten Wert aufweist, sind die Werte des letzten Produktes wieder proportional den Werten des Stromes i_{N} und werden zur Ermittlung von Nebengrössen über den ersten Umschalter 20, den zweiten Analog/Digital-Wandler 15, den dritten Ausgang der Eingangsschaltung 3 und die Interfaceschaltung 4 der Rechneranordnung 5 zugeführt, während die Werte des ersten Produktes proportional der Wirkleistung sind und zur Ermittlung der Hauptgrösse über den ersten Umschalter 20 und den Signal/Frequenz-Wandler 13 dem Zähler 14 zugeführt werden, der wieder auf die bereits beschriebene Weise durch Vorwärts- und Rückwärtszählen die zugehörigen Werte der Wirkenergie ermittelt, wobei anschliessend wieder die so ermittelten Werte zur Speicherung und gegebenenfalls weiteren Aufbereitung über den zweiten Ausgang der Eingangsschaltung 3 und die Interfaceschaltung 4 der Rechneranordnung 5 zugeführt werden. Die letzte dient wieder der Ermittlung von Werten der Haupt- und Nebengrössen. Das Umschalten von der Ermittlung der Hauptgrösse auf die Ermittlung der Nebengrösse erfolgt nur kurzzeitig, 1% bis 2% der Gesamtzeit, nämlich gerade lange genug, damit die Abtast/ Halte-Schaltung des Analog/Digital-Wandlers 15 ihren eingeschwungenen Zustand erreichen kann.

Ansonsten arbeitet die Anordnung der zweiten Variante gleich wie diejenige der ersten Variante. Insbesondere erreicht die Spannung u_{N} zur Berechnung von Nebengrössen wieder in einer vorteilhaften Ausführung der Anordnung über den fakultativ vorhandenen Spannungssensor 8, den ersten Analog/Digital-Wandler 12, den ersten Ausgang der Eingangsschaltung 3 und die Interfaceschaltung 4 die Rechneranordnung 5.

Wenn die Nebengrössen nur Werte der Spannung u_{N} oder des Stromes i_{N} beinhalten, dann ist wieder einer der beiden Analog/ Digital-Wandler 12 oder 15 überflüssig und kann mit seiner zugehörigen Ansteuerungsschaltung 8 bzw. 16;20;21;22 weggelassen werden. In diesem Fall besitzt die Eingangsschaltung 3 wieder nur mehr zwei Ausgänge.

Somit gilt, dass in der zweiten Variante der Strom i_{N} immer auf einen der beiden Eingänge des Multiplizierers 10 geführt ist, dessen Ausgang in der Regel mittels des ersten Umschalters 20 entweder zur Ermittlung mindestens einer Hauptgrösse über den Signal/Frequenz-Wandler 13 mit der Rechneranordnung 5 verbunden ist oder zur Berechnung mindestens einer Nebengrösse über den Analog/Digital-Wandler 15 auf die Rechneranordnung 5 geführt ist. In demjenigen Fall, in dem der Ausgang des Multiplizierers 10 über den Signal/Frequenz-Wandler 13 mit der Rechneranordnung 5 verbunden ist, wird der andere der beiden Eingänge des Multiplizierers 10 von der Spannung u_{N} über den Spannungs/Strom-Wandler 9 und den zweiten Umschalter 21 gespeist. In demjenigen Fall dagegen, in dem der Ausgang des Multiplizierers 10 über den Analog/Digital-Wandler 15 auf die Rechneranordnung 5 geführt ist, ist der andere der beiden Eingänge des Multiplizierers 10 über den dritten Umschalter 22 vom konstanten Referenzstrom I_{R} der Konstantstromquelle 16 gespeist.

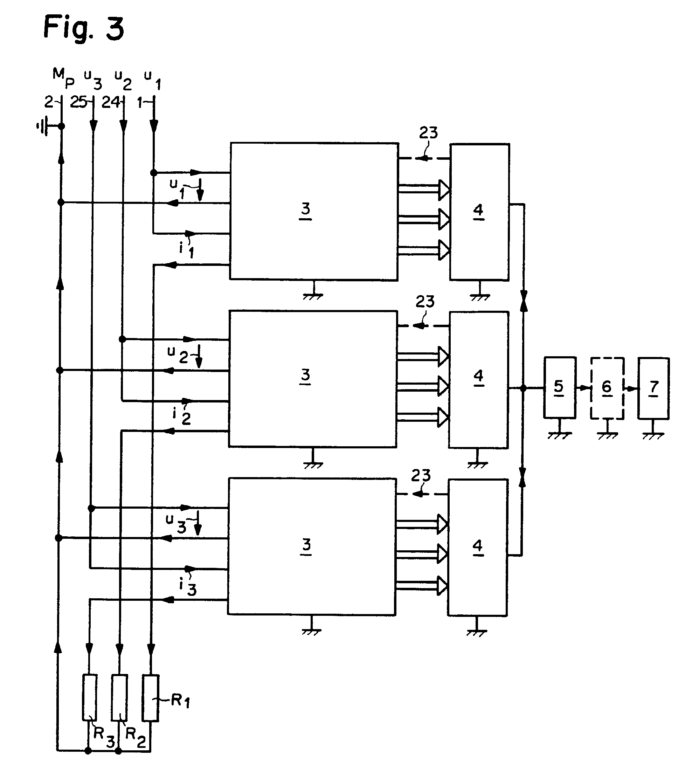

Die in der Fig. 3 dargestellte dreiphasige Anordnung wird über vier Leiter 1, 2, 24 und 25 von drei Spannungen u₁, u₂ und u₃ eines Dreiphasen-Energieversorgungsnetzes gespeist. Der Leiter 2 ist ein Nullleiter und die drei Leiter 1, 24 und 25 sind Phasenleiter. Die drei Spannungen u₁, u₂ und u₃ sind ihrerseits vorzugsweise die Phasenspannungen des Dreiphasen-Energieversorgungsnetzes. Der Leiter 2 liegt dann am gemeinsamen Bezugspotential Mp der drei Spannungen u₁, u₂ und u₃ und ist in der Regel geerdet.

Zu jeder der drei Spannungen u₁, u₂ und u₃ gehört eine Eingangsschaltung 3 und eine Interfaceschaltung 4, die beide in der angegebenen Reihenfolge in Kaskade geschaltet sind und einen gleichen innern Aufbau besitzen wie diejenigen der einphasigen Anordnung (siehe Fig. 1 und Fig. 2). Die Eingangsschaltungen 3 weisen somit wieder jeweils zwei Eingangsgrössen auf, nämlich eine der Spannungen u₁, u₂ oder u₃ als erste Eingangsgrösse und einen zu dieser Spannung gehörenden Strom i₁, i₂ oder i₃ als zweite Eingangsgrösse. Die Spannungen u₁, u₂ und u₃ speisen dabei wieder zweipolig einen ersten Eingang und die Ströme i₁, i₂ und i₃ wieder zweipolig einen zweiten Eingang der zugehörigen Eingangsschaltung 3. Die Eingänge der Eingangsschaltungen 3 sind gleichzeitig Eingänge der dreiphasigen Anordnung. Dabei fliesst der Strom i₁, i₂ und i₃ jeweils bei einem ersten Pol des zweiten Eingangs in die zugehörige Eingangsschaltung 3 hinein, durchquert diese und verlässt sie anschliessend wieder bei einem zweiten Pol des zweiten Eingangs, um anschliessend eine Phasenlast zu durchqueren, die in der Fig. 3 symbolisch durch einen der drei Last-widerstände R₁, R₂ oder R₃ dargestellt ist, deren gemeinsamer Sternpunkt mit dem Leiter 2 verbunden ist. In der Fig. 3 gilt wieder die Annahme, dass die Eingangsschaltung 3 drei Ausgänge besitzt, die über je eine Busverbindung mit der zugehörigen Interfaceschaltung 4 verbunden sind. Alle Interfaceschaltungen 4 sind mit einer gemeinsamen nachgeschalteten Kaskadenschaltung 5;6;7 verbunden, die in der angegebenen Reihenfolge aus der Rechneranordnung 5, der fakultativ vorhandenen weiteren Interfaceschaltung 6 und der Anzeige 7 besteht.

Wenn die Eingangsschaltungen 3 den in der Fig. 2 dargestellten Aufbau besitzen, besitzt jede Interfaceschaltung 4 noch einen zusätzlichen Ausgang, der mit einem weiteren Eingang der zugehörigen Eingangsschaltung 3 verbunden ist, wobei über diese Verbindung, die in der Fig. 3 gestrichelt dargestellt ist, das von der Rechneranordnung 5 kommende Steuersignal 23 von der Interfaceschaltung 4 zur zugehörigen Eingangsschaltung 3 übertragen wird. Alle Eingangsschaltungen 3 werden dabei z. B. vom gleichen Steuersignal 23 angesteuert.

Die Arbeitsweise der dreiphasigen Anordnung ist gleich wie diejenige der entsprechenden einphasigen Anordnung mit dem Unterschied, dass dreimal soviele Grössen ermittelt, ausgewertet, gespeichert und angezeigt werden können.

In allen Varianten können ausserdem die Ströme i_{N}, i₁, i₂ und i₃ über je einen nicht dargestellten Stromwandler oder Shuntwiderstand dem Multiplzierer 10 und/oder dem Strom/ Spannungs-Wandler 11 zugeführt werden.

In allen Varianten enthalten die Multiplizierer 10 und 17 und damit auch der Strom/Spannungs-Wandler 11 vorzugsweise je ein Hallelement, welches dem vom Srom i_{N} erzeugten Magnetfeld und dessen Induktion B_{N} ausgesetzt ist.

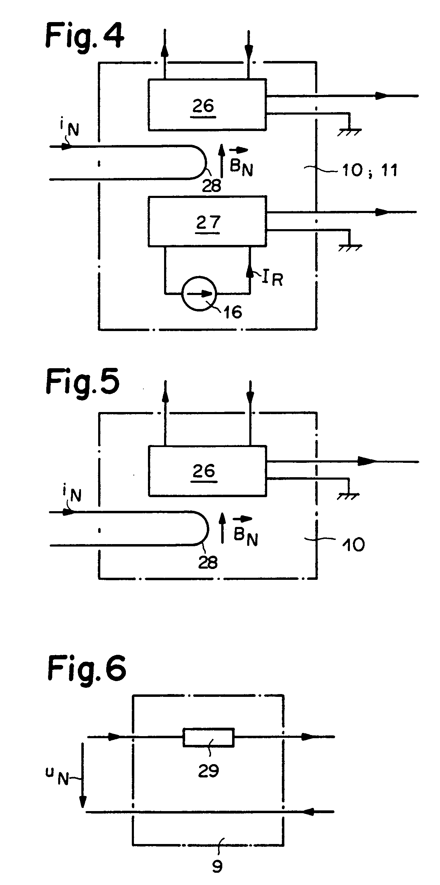

Die aus dem Multiplizierer 10 und dem den Multiplizierer 17 enthaltenden Strom/Spannungs-Wandler 11 bestehende Kombination 10;11 der ersten Variante (siehe Fig. 1) besitzt dann den in der Fig. 4 dargestellten Aufbau, während der Multiplizierer 10 der zweiten Variante (siehe Fig. 2) dann den in der Fig. 5 dargestellten Aufbau aufweist.

Der Stromeingang eines ersten Hallelementes 26 bildet in beiden Varianten (siehe Fig. 4 und Fig. 5) jeweils den ersten Eingang des Multiplizierers 10, während die Hallspannung am Ausgang des ersten Hallelementes 26 in allen Fällen dem Ausgangssignal des Multiplizierers 10 entspricht. Der Stromeingang des ersten Hallelementes 26 wird immer über den Spannungs/Strom-Wandler 9 von der Spannung u_{N} gespeist. In der in der Fig. 4 dargestellten Kombination 10;11 ist der Stromeingang eines zweiten Hallelementes 27 vom konstanten Referenzstrom I_{R} der Konstantstromquelle 16 gespeist, während die Hallspannung des zweiten Hallelementes 27 dem Ausgangssignal des Strom/Spannungs-Wandlers 11 entspricht. Der Strom i_{N} durchfliesst vorzugsweise eine U-förmige Stromschlaufe 28 und erzeugt dabei die Induktion B_{N}. Die beiden Hallelemente 26 und 27 sind dann dieser Induktion B_{N} ausgesetzt, z. B. indem sie in einem Luftspalt eines gemeinsamen ferromagnetischen Kerns angeordnet sind, in dessen Innern die Induktion B_{N} mit Hilfe der Stromschlaufe 28 durch den Strom i_{N} erzeugt wird.

Der in der Fig. 5 dargestellte Multiplizierer 10 der zweiten Variante unterscheidet sich von der in der Fig. 4 dargestellten Kombination 10;11 nur dadurch, dass das zweite Hallelement 27 und die Konstantstromquelle 16 fehlen.

Der Spannungs/Strom-Wandler 9 ist vorzugsweise ein Reihenwiderstand 29 und besitzt dann den in der Fig. 6 dargestellten Aufbau. Dabei ist innerhalb des Spannungs/Strom-Wandlers 9 dessen erster Eingangspol über den Reihenwiderstand 29 mit einem ersten Ausgangspol und sein zweiter Eingangspol unmittelbar mit einem zweiten Ausgangspol jeweils des Spannungs/Strom-Wandlers 9 verbunden.

## Patentansprüche

1. Anordnung zur Ermittlung von Werten elektrischer Grössen, die von Messwerten mindestens einer elektrischen Eingangsgrösse der Anordnung ableitbar sind, wobei die zu ermittelnden elektrischen Grössen mindestens aus einer Nebengrösse und mindestens einer Hauptgrösse bestehen, welche letztere eine zu messende Energie ist, die geforderte Genauigkeit und/oder Fälschungssicherheit bei der Ermittlung aller Hauptgrössen grösser ist als bei der Ermittlung aller Nebengrössen und mindestens eine spannung (u_{N}, u₁, u₂, u₃) sowie mindestens ein zur Spannung (u_{N}, u₁, u₂, u₃) gehörender Strom (i_{N}, i₁, i₂, i₃) zwei elektrische Eingangsgrössen der Anordnung sind, dadurch gekennzeichnet, dass ein Multiplizierer (10) oder ein erster und ein zweiter Multiplizierer (10, 17) vorhanden sind, dass der Strom (i_{N}, i₁, i₂, i₃) auf einen ersten Eingang des Multiplizierers (10) beziehungsweise auf je einen ersten Eingang der beiden Multiplizierer (10, 17) geführt ist, dass der Ausgang des Multiplizierers (10) abwechselnd zur Ermittlung der Hauptgrösse über einen Signal/Frequenz-Wandler (13) beziehungsweise zur Ermittlung der Nebengrösse über einen Analog/Digital-Wandler (15) auf eine Rechneranordnung (5) geführt ist, während gleichzeitig zur Ermittlung der Hauptgrösse die Spannung (u_{N}, u₁, u₂, u₃) beziehungsweise zur Ermittlung der Nebengrösse ein konstanter Referenzstrom (I_{R}) auf einen zweiten Eingang des Multiplizierers (10) geführt sind, oder dass, bei vorhandenem zweitem Multiplizierer (17), die Spannung (u_{N}, u₁, u₂, u₃) auf einen zweiten Eingang des ersten Multiplizierers (10) und ein konstanter Referenzstrom (I_{R}) auf einen zweiten Eingang des zweiten Multiplizierers (17) geführt ist, während der Ausgang des ersten Multiplizieres (10) zur Ermittlung der Hauptgrösse über einem Signal/Frequenz-Wandler (13) und der Ausgang des zweiten Multiplizieres (17) zur Ermittlung der Nebengrösse über einem Analog/Digital-Wandler (15) auf eine Rechneranordnung (5) geführt ist.

2. Anordnung nach Anspruch 1, dadurch gekennzeichnet, dass bei nichtvorhandenem zweitem Multiplizierer (17) der Ausgang des Multiplizierers (10) mittels eines Umschalters (20;21;22 oder 20) abwechselnd über den Signal/Frequenz-Wandler (13) beziehungsweise den Analog/Digital-Wandler (15) mit der Rechneranordnung (5) verbunden ist und dass gleichzeitig die Spannung (u_{N}, u₁, u₂, u₃) beziehungsweise der konstante Referenzstrom (I_{R}) mittels des Umschalters (20;21;22) oder weiterer Umschalter (21, 22) auf den zweiten Eingang des Multiplizierers (10) geführt sind.

3. Anordnung nach Anspruch 1 oder 2, dadurch gekennzeichnet, dass der zweite Eingang des Multiplizierers (10) bzw. des ersten Multiplizierers (10) über einen Spannungs/Strom-Wandler (9) von der Spannung (u_{N}, u₁, u₂, u₃) gespeist ist.

4. Anordnung nach Anspruch 3, dadurch gekennzeichnet, dass der Spannungs/Strom-Wandler (9) ein Reihenwiderstand (29) ist.

5. Anordnung nach einem der Ansprüche 1 bis 4, dadurch gekennzeichnet, dass mindestens ein Multiplizierer (10, 17) ein Hallelement (26 bzw. 27) enthält, welches einem vom Strom (i_{N}, i₁, i₂, i₃) erzeugten Magnetfeld ausgesetzt ist und dessen stromeingang ein Eingang des betreffenden Multiplizierers (10, 17) ist.

6. Anordnung nach einem der Ansprüche 1 bis 5, dadurch gekennzeichnet, dass die spannung (u_{N}, u₁, u₂, u₃) über einen Spannungssensor (8) und einen dem letzteren nachgeschalteten weiteren Analog/Digital-Wandler (12) auf die Rechneranordnung (5) geführt ist.

7. Anordnung nach einem der Ansprüche 1 bis 6, dadurch gekennzeichnet, dass die Rechneranordnung (5) ein Mikrocomputer ist.

8. Anordnung nach einem der Ansprüche 1 bis 7, dadurch gekennzeichnet, dass mindestens eine der Hauptgrössen gleichzeitig auch eine Nebengrösse ist, deren Ermittlung zur Detektion von Fehlern in der Anordnung oder von Fälschungen dient.

9. Anordnung nach Anspruch 8, dadurch gekennzeichnet, dass die Hauptgrösse, die gleichzeitig auch Nebengrösse ist, die zu messende Energie ist.

10. Anordnung nach einem der Ansprüche 1 bis 9, dadurch gekennzeichnet, dass mindestens eine der folgenden Grössen, Effektivwert der Spannung (u_{N}, u₁, u₂, u₃) oder des Stromes (i_{N}, i₁, i₂, i₃), Voltstunden, Voltquadratstunden, Amperequadratstunden, Wirkleistung, Blindleistung, Blindenergie, Scheinleistung, Scheinenergie oder Leistungsfaktor, eine Nebengrösse ist.

## Claims

1. An arrangement for ascertaining values of electrical parameters which can be derived from measurement values of at least one electrical input parameter of the arrangement, wherein the electrical parameters to be ascertained comprise at least one secondary parameter and at least one main parameter, which latter is an energy to be measured, the required level of accuracy and/or safeguard against falsification is greater when ascertaining all main parameters than when ascertaining all secondary parameters, and at least one voltage (u_{N}, u₁, u₂, u₃ ) and at least one current (i_{N}, i₁, i₂, i₃) associated with the voltage (u_{N}, u₁, u₂, u₃ ) are two electrical input parameters of the arrangement, characterised in that there are provided a multiplier (10) or a first and a second multiplier (10, 17), that the current (i_{N}, i₁, i₂, i₃) is taken to a first input of the multiplier (10) or to a first input of each of the two multipliers (10, 17) respectively, that the output of the multiplier (10) is taken alternately for ascertaining the main parameter by way of a signal-frequency converter (13) or for ascertaining the secondary parameter by way of an analog-digital converter (15) to a computer arrangement (5) while at the same time for ascertaining the main parameter the voltage (u_{N}, u₁, u₂, u₃ ) and for ascertaining the secondary parameter a constant reference current (I_{R}) are taken to a second input of the multiplier (10), or that, when the arrangement has the second multiplier ( 17 ), the voltage (u_{N}, u₁, u₂, u₃ ) is taken to a second input of the first multiplier (10) and a constant reference current (I_{R}) is taken to a second input of the second multiplier (17), while the output of the first miltiplier (10) is taken to a computer arrangement (5) for ascertaining the main parameter by way of a signal-frequency converter (13) and the output of the second miltiplier (17) is taken to the computer arrangement (5) for ascertaining the secondary parameter by way of an analog-digital converter (15).

2. An arrangement according to claim 1 characterised in that, when the arrangement does not have the second multiplier (17), the output of the miltiplier (10) is connected to the computer arrangement (5) alternately by means of a change-over switch (20; 21; 22 or 20) by way of the signal-frequency converter (13) and the analog-digital converter (15) respectively and that at the same time the voltage (u_{N}, u₁, u₂, u₃) and the constant reference current (I_{R}) are respectively passed to the second input of the miltiplier (10) by means of the change-over switch (20; 21; 22) or further change-over switches (21, 22 ).

3. An arrangement according to claim 1 or claim 2 characterised in that the second input of the multiplier ( 10 ) or the first miltiplier (10) is fed with the voltage (u_{N}, u₁, u₂, u₃ ) by way of a voltage-current converter (9).

4. An arrangement according to claim 3 characterised in that the voltage-current converter (9) is a series resistor (29).

5. An arrangement according to one of claims 1 to 4 characterised in that at least one miltiplier (10, 17) includes a Hall element (26 or 27 respectively) which is exposed to a magnetic field generated by the current (i_{N}, i₁, i₂, i₃ ), the current input of the Hall element being an input of the respective miltiplier (10, 17).

6. An arrangement according to one of claims 1 to 5 characterised in that the voltage (u_{N}, u₁, u₂, u₃ ) is passed to the computer arrangement (5) by way of a voltage sensor (8) and a further analog-digital converter (12) connected on the output side of the voltage sensor.

7. An arrangement according to one of claims 1 to 6 characterised in that the computer arrangement (5) is a microcomputer.

8. An arrangement according to one of claims 1 to 7 characterised in that at least one of the main parameters is at the same time also a secondary parameter, the ascertainment of which serves for the detection of faults in the arrangement or falsification situations.

9. An arrangement according to claim 8 characterised in that the main parameter which is at the same time also a secondary parameter is the energy to be measured.

10. An arrangement according to one of claims 1 to 9 characterised in that at least one of the following parameters is a secondary parameter: effective value of the voltage (u_{N}, u₁, u₂, u₃) or the current (i_{N}, i₁, i₂, i₃ ), volt hours, volt square hours, ampere square hours, active power, reactive power, reactive energy, apparent power, apparent energy or power factor.

## Revendications

1. Montage de détermination des valeurs de grandeurs électriques qui peuvent être tirées des mesures d'au moins une grandeur électrique d'entrée du montage, les grandeurs électriques devant être déterminées se composant d'au moins une grandeur secondaire et d'au moins une grandeur principale, cette dernière étant une énergie devant être mesurée, la précision et/ou la sécurité contre les falsifications qui est exigée pour la détermination de toutes les grandeurs principales étant supérieure à celle qui l'est par la détermination de toutes les grandeurs secondaires et au moins une tension (u_{N}, u₁, u₂, u₃) ainsi qu'au moins un courant (i_{N}, i₁, i₂, i₃) correspondant à la tension (u_{N}, u₁, u₂, u₃) étant deux grandeurs électriques d'entrée du montage, caractérisé en ce qu'il comprend un multiplicateur (10) ou un premier et un second multiplicateurs (10, 17), en ce que le courant (i_{N}, i₁, i₂, i₃) est dirigé sur une première entrée du multiplicateur (10) ou sur une première entrée de chacun des deux multiplicateurs (10, 17), en ce que la sortie du multiplicateur (10) est connectée à un dispositif de calcul (5) en alternance pour la détermination d'une grandeur principale par l'intermédiaire d'un convertisseur (13) de signal en fréquence et respectivement pour la détermination de la grandeur secondaire par l'intermédiaire d'un convertisseur analogique-numérique (15), tandis que, simultanément, pour la détermination de la grandeur principale, la tension (u_{N}, u₁, u₂, u₃) et, respectivement, pour la détermination de la grandeur secondaire, un courant constant de référence (I_{R}) sont dirigés sur une seconde entrée du multiplicateur (10) ou en ce que, en présence du second multiplicateur (17), la tension (u_{N}, u₁, u₂, u₃) est dirigée sur une seconde entrée du premier multiplicateur (10) et un courant constant de référence (I_{R}) est dirigé sur une seconde entrée du second multiplicateur (17), tandis que la sortie du premier multiplicateur (10) est dirigée sur un dispositif de calcul (5) par l'intermédiaire d'un convertisseur (13) de signal en fréquence pour la détermination de la grandeur principale et la sortie du second multiplicateur (17) est dirigée sur ce dispositif de calcul (5) par l'intermédiaire d'un convertisseur analogique-numérique (15) pour la détermination de la grandeur secondaire.

2. Montage selon la revendication 1, caractérisé en ce qu'en l'absence du second multiplicateur (17), la sortie du multiplicateur (10) est connectée au dispositif de calcul (5) au moyen d'un commutateur (20 ; 21 ; 22 ou 20) en alternance par l'intermédiaire du convertisseur (13) de signal en fréquence et du convertisseur analogique-numérique (15) et en ce que, simultanément, la tension (u_{N}, u₁, u₂, u₃) ou le courant constant de référence (I_{R}) est dirigé sur la seconde entrée du multiplicateur (10) au moyen du commutateur (20 ; 21 ; 22) ou d'autres commutateurs (21, 22).

3. Montage selon la revendication 1 ou 2, caractérisé en ce que la seconde entrée du multiplicateur (10) ou du premier multiplicateur (10) est alimentée en la tension (u_{N}, u₁, u₂, u₃) par l'intermédiaire d'un convertisseur (9) de tension en courant.

4. Montage selon la revendication 3, caractérisé en ce que le convertisseur (9) de tension en courant est une résistance série (29).

5. Montage selon l'une des revendications 1 à 4, caractérisé en ce qu'au moins un multiplicateur (10, 17) comprend un élément à effet de Hall (26 ainsi que 27) qui est soumis à un champ magnétique généré par le courant (i_{N}, i₁, i₂, i₃) et dont l'entrée du courant est une entrée du multiplicateur correspondant (10, 17).

6. Montage selon l'une des revendications 1 à 5, caractérisé en ce que la tension (u_{N}, u₁, u₂, u₃) est dirigée sur le dispositif de calcul (5) par l'intermédiaire d'un détecteur de tension (8) et d'un autre convertisseur analogique-numérique (12) monté en aval de ce dernier.

7. Montage selon l'une des revendications 1 à 6, caractérisé en ce que le dispositif de calcul (5) est un micro-ordinateur.

8. Montage selon l'une des revendications 1 à 7, caractérisé en ce qu'au moins l'une des grandeurs principales est également aussi une grandeur secondaire dont la détermination est utilisée pour la détection de défauts du montage ou de falsifications.

9. Montage selon la revendication 8, caractérisé en ce que la grandeur principale qui est aussi une grandeur secondaire est l'énergie devant être mesurée.

10. Montage selon l'une des revendications 1 à 9, caractérisé en ce qu'au moins l'une des grandeurs suivantes est une grandeur secondaire : valeur effective de la tension (u_{N}, u₁, u₂, u₃) ou du courant (i_{N}, i₁, i₂, i₃), volts-heure, volts-heure-carré, ampères-heure, ampères-heure-carré, puissance active, puissance réactive, énergie réactive, puissance apparente, énergie apparente ou facteur de puissance.
